# EUROPEAN PATENT APPLICATION

(11) **EP 4 746 643 A1**
(43) Date of publication of application: **20.05.2026**
(21) Application number: 25173370.5
(22) Date of filing: 29.04.2025
(51) Int. Cl.: H10F 77/14, H10F 77/20, H10F 77/30

(54) **PASSIVATED CONTACT SOLAR CELL AND PHOTOVOLTAIC MODULE**

(30) Priority: 18.11.2024 CN 202411640214
(71) Applicant: Tongwei Solar (Chengdu) Co., Ltd., Chengdu, Sichuan 610299 (CN)
(72) Inventor: YANG, Lei, Chengdu 610299 (CN); WANG, Gong Xin, Chengdu 610299 (CN); YU, Bin, Chengdu 610299 (CN); LV, Ai Wu, Chengdu 610299 (CN)
(74) Representative: Gill Jennings & Every LLP

(57) **Abstract**

The present disclosure provides a passivated contact solar cell and a photovoltaic module. The passivated contact solar cell includes a silicon substrate (1). The silicon substrate includes a first region (11) and a third region (13) spaced apart from each other on a back side (101) thereof. In the first region, the back side of the silicon substrate is sequentially provided with a dielectric layer (2), a first doped layer (3), and a first passivation layer (4) thereon. The dielectric layer and the first doped layer form a passivated contact structure in the first region. In the third region, the back side of the silicon substrate is also provided with the first passivation layer thereon. A second region is arranged between the first region and the third region. The second region is provided with a stepped structure (5) having at least two steps.

## Description

### TECHNICAL FIELD

The present disclosure relates to the field of solar cells, and in particular, to a passivated contact solar cell and a photovoltaic module.

### BACKGROUND

The passivated contact solar cell is a type of solar cell based on selective carrier transport and has significant application potential.

The passivated contact structure of the current passivated contact solar cell primarily consists of a dielectric layer and a doped layer (also referred to as a Poly layer). However, the doped layer inherently possesses extinction capability, leading to increased optical losses in the passivated contact solar cell, which affects the short-circuit current and, consequently, the photoelectric conversion efficiency of the passivated contact solar cell. Therefore, finding ways to reduce optical losses in the passivated contact solar cell to increase the short-circuit current and improve the photoelectric conversion efficiency of the solar cell has become an urgent technical problem that needs to be addressed.

### SUMMARY

In order to solve the above-mentioned technical problem, the present disclosure provides a passivated contact solar cell and a photovoltaic module. The optical losses in the passivated contact solar cell is reduced, so that the short-circuit current and photoelectric conversion efficiency of the passivated contact solar cell are improved.

In a first aspect, the present disclosure provides a passivated contact solar cell including a silicon substrate. The silicon substrate includes a first region and a third region spaced apart from each other on a back side thereof. In the first region, the back side of the silicon substrate is sequentially provided with a dielectric layer, a first doped layer, and a first passivation layer thereon. The dielectric layer and the first doped layer form a passivated contact structure in the first region. In the third region, the back side of the silicon substrate is also provided with the first passivation layer thereon. A second region is arranged between the first region and the third region. The second region is provided with a stepped structure having at least two steps.

In some embodiments of the present disclosure, the stepped structure includes a first step and a second step. The first step includes a first subsurface and a second subsurface intersect with each other. The second step includes a third subsurface and a fourth subsurface intersect with each other.

In some embodiments of the present disclosure, a distance between the first subsurface and the third subsurface is H₁, where 0.05 µm ≤ I₁ ≤ 0.2 µm.

In some embodiments of the present disclosure, a distance between the third subsurface and a first plane is H₂, where 0.5 µm ≤ H₂ ≤ 8 µm. The first plane refers to a portion of a surface of the first passivation layer facing away from the silicon substrate that is located in the third region.

In some embodiments of the present disclosure, an included angle between the third subsurface and the fourth subsurface is α, where α ≥ 90°.

In some embodiments of the present disclosure, the second subsurface intersects with the third subsurface.

In some embodiments of the present disclosure, a width of the third subsurface is W₁, where 0.01 µm ≤ W₁ ≤ 5 µm.

In some embodiments of the present disclosure, the stepped structure further includes a texture structure, and the texture structure is recessed relative to the third subsurface and/or the fourth subsurface.

In some embodiments of the present disclosure, the texture structure is located on a portion of the silicon substrate corresponding to the third subsurface; and/or, the texture structure is located on a portion of the silicon substrate corresponding to the fourth subsurface; and/or, the texture structures is located on a portion of the silicon substrate corresponding to a first boundary at which the third subsurface intersects with the fourth subsurface.

In some embodiments of the present disclosure, an average width of the texture structure is W₂, where 0.5 µm ≤ W₂ ≤ 10 µm.

In some embodiments of the present disclosure, the first region is provided with a first electrode. The first electrode penetrates through the first passivation layer to be in contact with the first doped layer.

In a second aspect, the present disclosure provides a photovoltaic module, including the solar cell described in the first aspect.

Compared with the prior art, the present disclosure has at least the following advantages:

The present disclosure provides the passivated contact solar cell and the photovoltaic module. The passivated contact solar cell includes the silicon substrate. The silicon substrate includes a first region and a third region spaced apart from each other on a back side thereof. In the first region, the back side of the silicon substrate is sequentially provided with a dielectric layer, a first doped layer, and a first passivation layer thereon. The dielectric layer and the first doped layer form a passivated contact structure in the first region. In the third region, the back side of the silicon substrate is also provided with the first passivation layer thereon. A second region is arranged between the first region and the third region. The second region is provided with a stepped structure having at least two steps. In the present disclosure, the second region forms a transition region between the first region and the third region. The stepped structure in the second region is configured to adjust an angle of incident light to facilitate the light to enter the solar cell, thereby improving the utilization rate of the incident light, reducing the optical losses in the solar cell, increasing the short-circuit current of the solar cell, and thus improving the photoelectric conversion efficiency of the solar cell.

### BRIEF DESCRIPTION OF THE DRAWINGS

FIG. 1 is a schematic structural view of a solar cell according to an embodiment of the present disclosure;
FIG. 2 is an enlarged partial schematic view of a region within a dotted circle in FIG. 1;
FIG. 3 is a schematic structural view of a stepped structure according to an embodiment of the present disclosure;
FIG. 4 is a schematic structural view of a stepped structure according to another embodiment of the present disclosure;
FIG. 5 is a schematic structural view of a stepped structure according to yet another embodiment of the present disclosure;
FIG. 6 is a schematic structural view of a texture structure according to an embodiment of the present disclosure;
FIG. 7 is a schematic structural view of a solar cell according to another embodiment of the present disclosure; and
FIG. 8 is a scanning electron microscope (SEM) image of a back side of a solar cell in Example 1 of the present disclosure.

Descriptions of reference numerals:
1-silicon substrate, 2-dielectric layer, 3-first doped layer, 4-first passivation layer, 5-stepped structure, 7-texture structure, 8-second doped layer, 9-second passivation layer, 10-anti-reflective layer, 11-first region, 12-second region, 13-third region, 51-first step, 52-second step, 61-first electrode, 62-second electrode, 101-back side, 102-light-receiving side, 511-first subsurface, 512-second subsurface, 521-third subsurface, and 522-fourth subsurface.

### DETAILED DESCRIPTION

In the present disclosure, the orientation or positional relationships indicated by the terms such as "upper", "lower", "left", "right", "front", "rear", "top", "bottom", "inner", "outer", "vertical", "horizontal", "transverse", and "longitudinal" are based on orientation or positional relationships shown in the accompanying drawings. These terms are mainly used to better describe the present disclosure and the embodiments thereof, and are not intended to limit the indicated apparatuses, elements, or components to have specific orientations or to require construction and operation in specific orientations.

Moreover, some of the above-mentioned terms may also be used to represent other meanings in addition to indicating the orientation or positional relationships. For example, the term "on" may, in certain cases, be used to indicate a certain attachment relationship or connection relationship. Those of ordinary skill in the art should understand specific meanings of these terms in the present disclosure according to specific situations.

Further, the terms "installed", "disposed", "provided with", "connected", and "coupled" should be understood in a broad sense. For example, it may be a fixed connection, a detachable connection, or an integrated construction; it may be a mechanical connection or an electrical connection; or it may be a direct connection, an indirect connection through an intermediate medium, or a communication between interiors of two apparatuses, elements, or components. Those of ordinary skill in the art should understand specific meanings of the above-mentioned terms in the present disclosure according to specific situations.

Additionally, the terms "first", "second", etc., are mainly used to distinguish between different apparatuses, elements, or components (specific categories and constructions may be the same or different), and are not intended to indicate or imply relative importance and quantity of the indicated apparatuses, elements, or components. Unless otherwise stated, "a plurality of" means two or more than two.

The technical solutions of the present disclosure will be further described below in conjunction with the embodiments and the accompanying drawings.

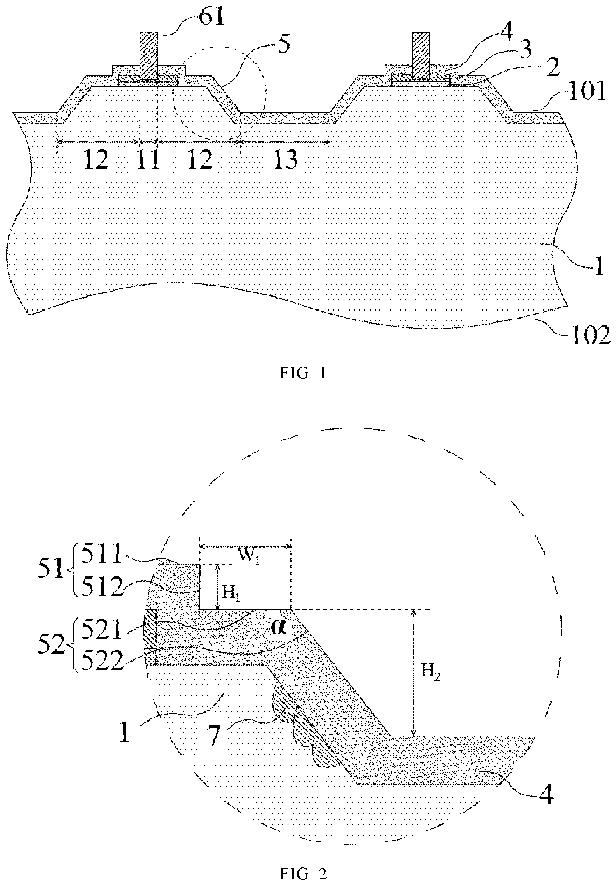

In a first aspect, the present disclosure provides a passivated contact solar cell. As shown in FIG. 1, the passivated contact solar cell includes a silicon substrate 1. A back side 101 of the silicon substrate 1 includes a first region 11 and a third region 13 which are spaced apart from each other. In the first region 11, the back side 101 of the silicon substrate 1 is sequentially provided with a dielectric layer 2, a first doped layer 3, and a first passivation layer 4 thereon. The dielectric layer 2 and the first doped layer 3 form a passivated contact structure in the first region 11. In the third region 13, the back side 101 of the silicon substrate 1 is also provided with the first passivation layer 4 thereon. A second region 12 is arranged between the first region 11 and the third region 13. The second region 12 is provided with a stepped structure 5. At least two steps are provided in the stepped structure 5. For example, two, three, four or five steps are provided in the stepped structure 5.

In the present disclosure, referring to FIG. 1, the first region 11 refers to a region on the back side 101 of the silicon substrate 1 that corresponds to an orthogonal projection of a first electrode 61 onto a surface of the silicon substrate 1. The second region 12 refers to a region on the back side 101 of the silicon substrate 1 that is provided with the stepped structure 5. The third region 13 refers to a region on the back side 101 of the silicon substrate 1 that is outside the first region 11 and the second region 12. In the present disclosure, the stepped structure 5 in the second region 12 is configured to adjust an angle of incident light to facilitate the light to enter the solar cell, thereby improving the utilization rate of the incident light, reducing the optical losses in the solar cell, increasing the short-circuit current of the solar cell, and thus improving the photoelectric conversion efficiency of the solar cell.

In some embodiments, the second region 12 may also be provided with the first passivation layer 4, for example, the first passivation layer 4 may cover the entire back side 101 of the silicon substrate 1. In some embodiments, the shape of the stepped structure 5 is defined by a back surface of the silicon substrate 1 (i.e., a surface of the silicon substrate 1 facing the first passivation layer 4) and a first surface of the first passivation layer 4 facing away from the silicon substrate 1. In some embodiments, the dielectric layer 2 and the first doped layer 3 may be provided in the second region 12. In some alternative embodiments, the dielectric layer 2 and the first doped layer 3 may not be provided in the second region.

In an optional embodiment, referring to FIG. 2 which is an enlarged partial schematic view of a region within a dotted circle in FIG. 1, the stepped structure 5 includes a first step 51 and a second step 52. The first step 51 includes a first subsurface 511 and a second subsurface 512 that intersect with each other. The second step 52 includes a third subsurface 521 and a fourth subsurface 522 that intersect with each other. In the present disclosure, the stepped structure 5 has two steps. The first step 51 serves as a height transition for the second step 52. The first doped layer 3 is either not provided or only partially provided beneath the second step 52. Under the combined effect of the first step 51 and the second step 52, the absorption of the light by the first doped layer 3 is reduced, thereby improving the photon utilization rate of the solar cell and reducing the optical losses in the solar cell. The first subsurface 511, the second subsurface 512, the third subsurface 521, and the fourth subsurface 522 may each be, for example, a portion of the first surface of the first passivation layer 4.

In an optional embodiment, referring to FIG. 2, a distance between the first subsurface 511 and the third subsurface 521 is H₁, where 0.05 µm ≤ H₁ ≤ 0.2 µm. For example, H₁ may be 0.05 µm, 0.1 µm, 0.15 µm, or 0.2 µm. By controlling H₁ within the above-mentioned range, photon absorption can be optimized, and the light absorption effect at the first step 51 can be improved by adjusting a film structure and a film thickness of the first passivation layer 4.

In an optional embodiment, referring to FIG. 2, a distance between the third subsurface 521 and a first plane is H₂, where 0.5 µm ≤ H₂ ≤ 8 µm. For example, H₂ may be 0.5 µm, 1 µm, 3 µm, 5 µm, or 8 µm. The first plane refers to a portion of the first surface of the first passivation layer 4 that is located in the third region 13. By controlling H₂ within the above-mentioned range, the passivation performance of the first passivation layer 4 at the second step 52 can be optimized, and the liquid absorption effect at the second step 52 can be improved.

In an optional embodiment, referring to FIG. 2, an included angle between the third subsurface 521 and the fourth subsurface 522 is α, where α ≥ 90°. For example, α may be 90°, 100°, 110°, 120°, or 135°. Observed along a length extension direction of the first electrode 61, the fourth subsurface 522 may be a surface perpendicular to the third subsurface 521; or, the fourth subsurface 522 may be a surface inclined relative to the third subsurface 521. By controlling α within the above-mentioned range, the incidence angle of light at the second step 52 can be optimized, thereby improving the utilization rate of the incident light.

In an optional embodiment, referring to FIG. 2, the second subsurface 512 intersects with the third subsurface 521. Accordingly, the first step 51 and the second step 52 can be connected, thereby forming the stepped structure 5 of the present disclosure, which is beneficial for reducing the optical losses in the passivated contact solar cell.

In an optional embodiment, referring to FIG. 2, a width of the third subsurface 521 is W₁, where 0.01 µm ≤ W₁ ≤ 5 µm. For example, W₁ may be 0.01 µm, 0.1 µm, 0.5 µm, 1 µm, 2 µm, 3 µm, 4 µm, or 5 µm. By controlling W₁ within the above-mentioned range, the incidence angle of light at the third subsurface 521 can be optimized, thereby improving the utilization rate of the incident light.

In an optional embodiment, referring to FIG. 2, the stepped structure 5 further includes a texture structure 7. The texture structure 7 may be provided at a side of the texture structure 7 close to the silicon substrate 1. For example, the texture structure 7 may be provided at a side of a second surface of the first passivation layer 4 facing the silicon substrate 1. The texture structure 7 is recessed relative to the third subsurface 521 and/or the fourth subsurface 522. In the present disclosure, the texture structure 7 may be a pit-shaped structure that is recessed downwardly relative to (i.e., recessed away from) the third subsurface 521 and/or the fourth subsurface 522. For example, the texture structure 7 may be formed by a portion of the back surface of the silicon substrate 1 that is recessed downwardly. In an example, the texture structure 7 may be a pit in a shape of an inverted pyramid, where an apex of the inverted pyramid is away from the third subsurface 521 and/or the fourth subsurface 522. A plurality of texture structures 7 may be provided. Among the plurality of texture structures 7, one texture structure 7 may be in the shape of the inverted pyramid, or multiple texture structures 7 may each be in the shape of the inverted pyramid, which is not specifically limited herein. Since the texture structures 7 can enhance the light absorption by reducing the reflection of the incident light based on the light-trapping principle, the utilization rate of light of the passivated contact solar cell can be improved, which is beneficial for improving the photoelectric conversion efficiency.

It should be noted that the stepped structure 5 in the present disclosure may include the texture structures 7 or do not include the texture structures 7, which is not limited herein.

The method for forming the texture structure 7 is not specifically limited herein, as long as the structure that is recessed downwardly relative to the third subsurface 521 and/or the fourth subsurface 522 can be formed. Exemplarily, the back side 101 of the silicon substrate 1 that is provided with the first doped layer 3 can be subjected to a laser etching treatment followed by a wet alkaline etching treatment to form the texture structures 7. Of course, the texture structures 7 may also be formed through other methods, which is not specifically limited in the present disclosure.

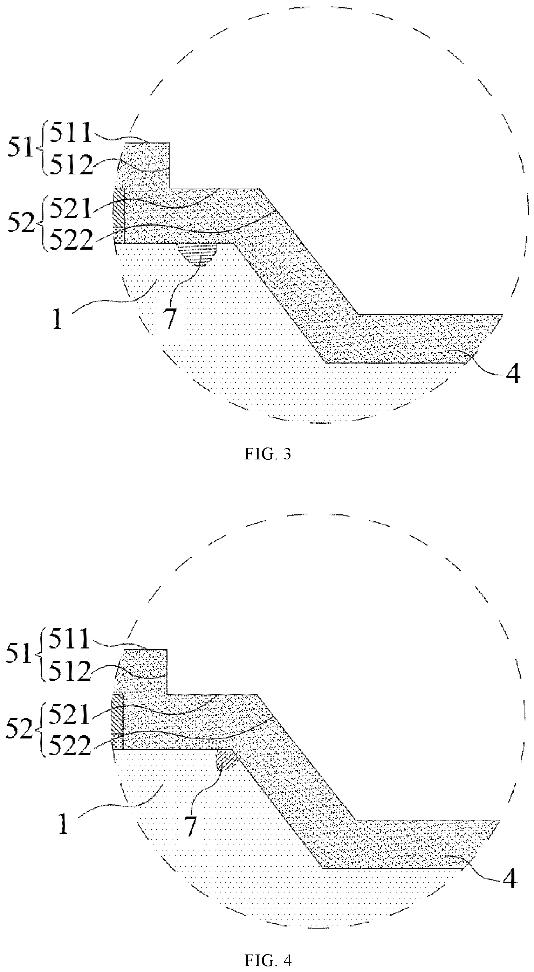

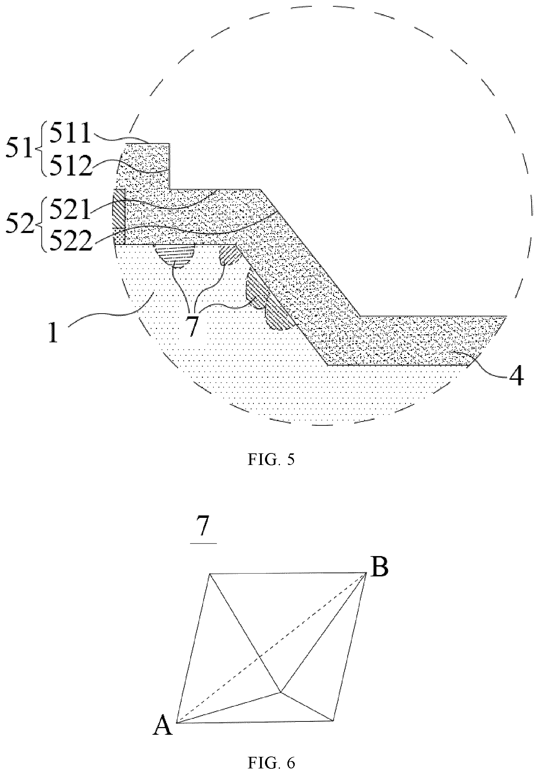

In an embodiment, referring to FIG. 3, the texture structure 7 is located on a portion of the silicon substrate 1 corresponding to the third subsurface 521, that is, the texture structure 7 is recessed downwardly relative to the third subsurface 521. In another embodiment, referring to FIG. 2, the texture structure 7 is located on a portion of the silicon substrate 1 corresponding to the fourth subsurface 522, that is, the texture structure 7 is recessed downwardly relative to the fourth subsurface 522. In yet another embodiment, referring to FIG. 4, the third subsurface 521 and the fourth subsurface 522 intersect at a first boundary, and the texture structure 7 is located on a portion of the silicon substrate 1 corresponding to the first boundary, that is, the texture structure 7 is recessed downwardly relative to the first boundary. In yet another embodiment, referring to FIG. 5, the texture structures 7 are located on a portion of the silicon substrate 1 corresponding to the third subsurface 521, a portion of the silicon substrate 1 corresponding to the fourth subsurface 522, and a portion of the silicon substrate 1 corresponding to the first boundary. The stepped structure 5 in the present disclosure has the above-mentioned texture structures 7, which can utilize the light-trapping principle to reduce the reflection of light incident to the third subsurface 521 and/or the fourth subsurface 522, thereby enhancing the light absorption and improving the utilization rate of light of the passivated contact solar cell.

In an embodiment, an average width of the texture structures 7 is W₂, where 0.5 µm ≤ W₂ ≤ 10 µm. For example, W₂ may be 0.5 µm, 1 µm, 2 µm, 3 µm, 4 µm, or 10 µm. The width of the texture structure 7 refers to a maximum value of a length of a line connecting any two points at a bottom of the texture structure. Exemplarily, referring to FIG. 6, when the texture structure 7 is in the shape of the inverted pyramid, the width of the texture structure 7 may be a length of a line connecting a point A and a point B on a bottom surface thereof, where the point A and the point B may be any two vertices at the bottom of the texture structure 7. In the present disclosure, the average width of the texture structures 7 refers to an average value of the widths of 10 texture structures 7 randomly selected from the stepped structure 5. By controlling W₂ within the above-mentioned range, an incidence angle of light can be adjusted to improve the utilization rate of the incident light.

In an embodiment, referring to FIG. 1, the first region 11 is provided with a first electrode 61 that penetrates through the first passivation layer 4 to be in contact with the first doped layer 3 to form an ohmic contact.

In an embodiment, a material of the first passivation layer 4 is selected from at least one of aluminum oxide, silicon nitride, and silicon oxynitride. The first passivation layer 4 formed by the above-mentioned materials is conducive to fully passivating an interface of the solar cell, thereby improving the performance of the solar cell.

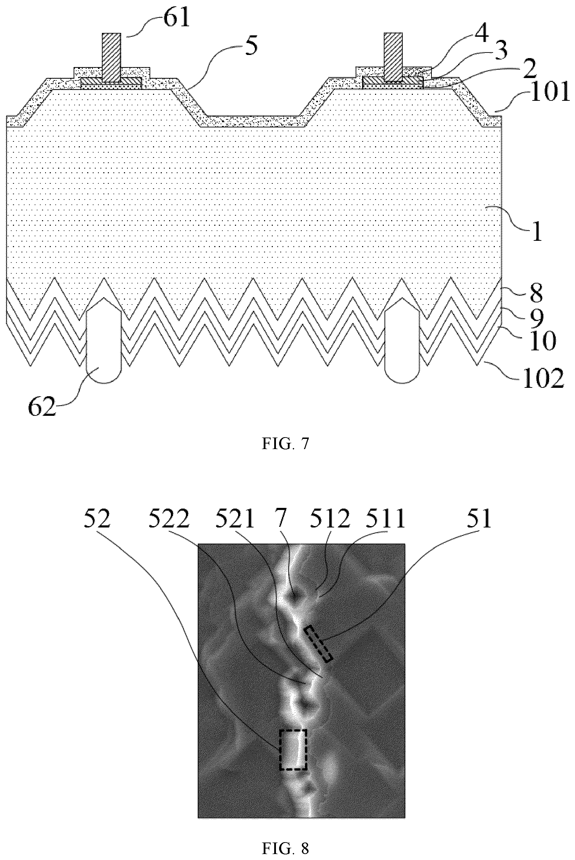

Additionally, in an embodiment, referring to FIG. 7, a light-receiving side 102 (which is opposite to the back side 101) of the passivated contact solar cell in the present disclosure is further sequentially provided with a second doped layer 8, a second passivation layer 9, an anti-reflection layer 10, and a second electrode 62 thereon. The light-receiving side 102 of the silicon substrate 1 has a textured surface. To better absorb the solar energy, the light-receiving side of the silicon substrate in the present disclosure has a textured surface, such as a pyramidal textured surface. The textured surface can provide a higher surface area for the solar cell while reducing light reflection, diffusion, etc. The method for producing the textured surface is not specifically limited in the present disclosure, as long as the objectives of the present disclosure can be achieved. For example, an existing magnetron sputtering method may be used.

In a second aspect, the present disclosure provides a photovoltaic module, including the solar cell described in the first aspect.

The present disclosure also provides a photovoltaic module for converting received light energy into electrical energy and transmitting the electric energy to an external load. The photovoltaic module includes: at least one cell string formed by connecting a plurality of the above-mentioned solar cells; an encapsulating adhesive film covering a surface of the cell string; and a cover plate covering a surface of the encapsulating adhesive film facing away from the cell string.

A material of the dielectric layer in the present disclosure may be selected from various dielectric materials, such as at least one of silicon oxide, magnesium fluoride, amorphous silicon, polycrystalline silicon, silicon carbide, silicon nitride, silicon oxynitride, aluminum oxide, or titanium oxide. Specifically, the dielectric layer may consist of a silicon oxide layer containing silicon oxide. This is because the silicon oxide layer has an excellent passivation performance, can minimize the recombination loss of minority carriers on a surface of a semiconductor substrate, and is a thin film with excellent durability for the subsequent high-temperature process. To better provide interface passivation for the substrate, a thickness of the dielectric layer may range from 0.1 nm to 5 nm. For example, the thickness of the dielectric layer may be 0.1 nm, 0.5 nm, 1 nm, 1.5 nm, 2 nm, 3 nm, 4 nm, 5 nm, etc. However, the present disclosure is not limited thereto, and the thickness of the dielectric layer may have various values. As a potential barrier for electrons and holes, the dielectric layer may be combined with a polycrystalline silicon layer to block the passage of the minority carriers. The dielectric layer may also function as a pinhole channel to allow carriers within the solar cell to move freely. Selective passage for majority carriers is achieved through heavily doped polycrystalline silicon, which is beneficial for reducing the recombination losses of the minority carriers. Additionally, the dielectric layer may function as a diffusion barrier to prevent a dopant in the doped polycrystalline silicon layer from diffusing into the semiconductor substrate.

The method for manufacturing the passivated contact solar cell is not specifically limited in the present disclosure. Exemplarily, the passivated contact solar cell may be manufactured by a method including:
Step A: providing a solar cell initial structure including the silicon substrate, the silicon substrate being provided with the first doped layer and the dielectric layer on the back side thereof and with the second doped layer on the light-receiving side thereof;
Step B: subjecting the back side of the silicon substrate to a patterning treatment to form the first region, the second region, and the third region on the back side of the silicon substrate;
Step C: forming the first passivation layer on the patterned back side of the silicon substrate using a plasma-enhanced chemical vapor deposition (PECVD) device, forming the second passivation layer on a surface of the second doped layer using an atomic layer deposition (ALD) device, and forming the anti-reflection layer on the surface of the second passivation layer using a PECVD device; and
Step D: manufacturing a first electrode and a second electrode on the back side and the light-receiving side of the solar cell initial structure, respectively.

In the step A of the present disclosure, the silicon substrate may be of a first conductivity type. A doping element in the second doped layer is of a second conductivity type. One of the first conductivity type and the second conductivity type is N-type, and the other one of the first conductivity type and the second conductivity type is P-type. For example, if the first conductivity type is N-type, then the second conductivity type is P-type; and if the first conductivity type is P-type, then the second conductivity type is N-type. The silicon substrate may be a silicon substrate that has been textured. The silicon substrate may have a thickness of 100 µm to 200 µm. The present disclosure is not limited thereto, as long as the objectives of the present disclosure can be achieved.

In the step B of the present disclosure, in an optional embodiment, the structure including the first region, the second region, and the third region described above may be formed on the back side of the silicon substrate through a laser etching process in combination with a wet etching process. The specific process includes:
a). sequentially depositing a dielectric layer, a phosphorus-doped amorphous silicon layer, and a silicon oxide mask layer on the back side of the silicon substrate using a plasma-enhanced chemical vapor deposition (PECVD) device, with a process temperature controlled between 400°C and 500°C;
b). converting amorphous silicon in the phosphorus-doped amorphous silicon layer into polycrystalline silicon and activating phosphorus atoms in the phosphorus-doped amorphous silicon layer, by a high-temperature annealing at 900°C to 980°C using a tube-type high-temperature device, to form the first doped layer, thereby obtaining a semi-finished solar cell;
c). scanning a predetermined pattern region (e.g., the third region designed) on the back side of the semi-finished solar cell by a green picosecond laser with a laser energy density of 150 mJ/cm² and 400 mJ/cm² to cause a portion of the silicon oxide mask layer in the corresponding region to be peeled off or denatured;
d). removing the oxide layer wrapped around a front surface and an edge of the solar cell using a chain-type HF device, and etching portions of the first doped layer and the dielectric layer in the laser-treated region by a tank-type wet alkaline etching with an alkaline solution at a concentration of 0.5 wt% to 5 wt%, thereby forming the pattern structure with the first region, the second region, and the third region.

In another optional embodiment, the structure with the first region, the second region, and the third region described above may be formed on the back side of the silicon substrate through a mask method in combination with a wet etching process. The specific process includes:
a'). sequentially depositing the dielectric layer and the phosphorus-doped amorphous silicon layer on the back side of the silicon substrate using a plasma-enhanced chemical vapor deposition (PECVD) device, with the process temperature controlled between 400°C and 500°C;
b'). converting amorphous silicon in the phosphorus-doped amorphous silicon layer into polycrystalline silicon and activating phosphorus atoms in the phosphorus-doped amorphous silicon layer, by a high-temperature annealing at 900°C to 950°C using a tube-type high-temperature device, to form the first doped layer, thereby obtaining a semi-finished solar cell.
c'). coating an alkali-resistant mask slurry onto a surface of the semi-finished solar cell by a chain coating method to form an alkali-resistant mask layer, and then laser scanning a predetermined pattern region (e.g., the third region that is designed) on the back side of the semi-finished solar cell to cause a portion of the alkali-resistant mask layer in the corresponding region to be distorted or denatured to expose the film/layer that is otherwise located underneath the portion of the alkali-resistant mask layer in the corresponding region;
d'). RCA cleaning: removing the oxide layer wrapped around a front surface and an edge of the solar cell using a chain-type HF device, and etching portions of the first doped layer and the dielectric layer in the exposed region by a tank-type wet alkaline etching with an alkaline solution at a concentration of 0.5 wt% to 2 wt%, thereby forming the pattern structure with the first region, the second region, and the third region.

In the step C of the present disclosure, the first passivation layer may be formed based on a PECVD process, the second passivation layer may be formed based on an ALD process, and the anti-reflection layer may be formed based on a PECVD process. The first passivation layer may be an aluminum oxide layer, which has a passivation function; the anti-reflection layer may be a silicon oxynitride layer, which has an anti-reflection function; and additionally, the second passivation layer may be manufactured on the back side of the solar cell initial structure, which may be a silicon oxynitride layer, having a passivation function.

The thicknesses of the various functional layers are not specifically limited in present disclosure, as long as the objectives of the present disclosure can be achieved. For example, the thickness of the first passivation layer is 70 nm to 120 nm, the thickness of the second passivation layer is 1 nm to 5 nm, and the thickness of the anti-reflection layer is 60 nm to 100 nm.

In the step D of the present disclosure, the first electrode and the second electrode may be manufactured respectively on the back side and the light-receiving side of the solar cell initial structure by a screen printing method.

The methods for controlling H₁ and H₂ are not specifically limited in present disclosure. For example, H₁ or H₂ typically increases with the increase in laser power during the laser etching treatment and with the increase in etching intensity during the wet etching. The etching intensity generally increases with the increase in etching time, the increase in etching temperature, or the increase in alkali solution concentration. Based on this, H₁ or H₂ may be controlled by controlling the laser power, the wet etching process, etc. The methods for controlling W₁ are not specifically limited in present disclosure. For example, W₁ typically increases with the increase in etching intensity during the wet etching. Based on this, W₁ may be controlled by controlling relevant process parameters of the wet etching. The methods for controlling W₂ are not specifically limited in present disclosure. For example, W₂ typically increases with the increase in etching intensity during the wet etching. Based on this, W₂ may be controlled by controlling the relevant process parameters of the wet etching.

The laser for laser etching is not specifically limited in present disclosure, as long as the objectives of the present disclosure can be achieved. Laser-related parameters of the present disclosure may be as follows: the type of the laser is at least one of a nanosecond laser, a picosecond laser, or a femtosecond laser; the type of the light is any of an infrared laser, a visible laser, or an ultraviolet laser; the energy density of the laser is 30 mJ/cm² to 3000 mJ/cm²; a wavelength of the laser is 300 nm to 1000 nm; or the shape of the laser spot may be circular or square.

The alkali solution for wet etching is not specifically limited in present disclosure, as long as the objectives of the present disclosure can be achieved. Exemplarily, the alkali solution may be a NaOH solution or a KOH solution, with a concentration of 0.5 wt% to 5 wt%. Additionally, the process temperature for alkali etching in the present disclosure may range from 60°C to 80°C, with an etching time of 200s to 1000s, as long as the textured structure can be formed at the subsurface of the stepped structure.

### Examples

The following provides a further description of the passivated contact solar cell and the photovoltaic module in the embodiments of the present disclosure in conjunction with the specific examples.

### Example 1

### <Providing a solar cell initial structure>

A solar cell initial structure that had been textured was provided. The solar cell initial structure included a silicon substrate. The silicon substrate was provided with a first doped layer, a dielectric layer, and a silicon oxide mask layer on a back side thereof, and with a second doped layer on a light-receiving side thereof. The silicon substrate was an N-type silicon wafer with a thickness of 125 µm. A doping element in the first doped layer was phosphorus (P) element, and a doping element in the second doped layer was boron (B) element.

### <Patterning treatment>

A green picosecond laser was used to scan a predetermined pattern reigon designed on a back side of a semi-finished solar cell to cause the silicon oxide mask layer in the corresponding region to be distorted or denatured. The portions of the first doped layer and the dielectric layer in the corresponding region were removed to form a preliminarily stepped structure. The oxide layer wrapped around a front surface and an edge of the solar cell was removed by a chain type HF device. Thereafter, a tank-type wet alkaline etching was performed to form a pattern structure having a first region, a second region, and a third region.

### < Manufacturing a first passivation layer>

A first passivation layer with a thickness of 80 nm was deposited on the back side of the patterned silicon substrate using a PECVD device.

### < Manufacturing a second passivation layer and an anti-reflection layer>

A second passivation layer with a thickness of 5 nm was deposited on a surface of the second doped layer facing away from the silicon substrate using an ALD device, and then an anti-reflection layer with a thickness of 80 nm was deposited on a surface of the second passivation layer using a PECVD device.

### <Manufacture of electrodes>

A first electrode and a second electrode were manufactured respectively on the back side and the light-receiving side of the solar cell initial structure by a screen printing method, to form a solar cell structure shown in FIG. 7.

### Examples 2-6

Examples 2-6 are substantially the same as Example 1, except that in <Patterning treatment>, H₁, H₂, W₁, and W₂ were controlled according to Table 1 by adjusting process parameters such as the laser power and the concentration of the alkali solution for wet etching.

**Table 1: Relevant process parameters in Examples 1 to 6**

| | H₁ (µm) | H₂ (µm) | W₁ (µm) | W₂ (µm) |
|---|---|---|---|---|
| Example 1 | 0.05 | 0.5 | 0.5 | 0.5 |
| Example 2 | 0.08 | 2 | 2 | 0.5 |
| Example 3 | 0.12 | 3 | 3 | 0.5 |
| Example 4 | 0.2 | 5 | 5 | 0.5 |
| Example 5 | 0.12 | 3 | 3 | 1 |
| Example 6 | 0.12 | 3 | 3 | 3 |

Open-circuit voltage, short-circuit current, and fill factor testing:
The current (I)-voltage (V) curves of the solar cells in Examples 1 to 6 were tested using an I-V testing machine (Model: MX-MPVC-A20) to obtain the open-circuit voltages, the short-circuit current densities, and the fill factors of the solar cells.

Photoelectric conversion efficiency testing:
The current (I)-voltage (V) curves of the solar cells in Examples 1 to 6 were tested using an I-V testing machine (Model: MX-MPVC-A20) to obtain the photoelectric conversion efficiencies (Eta) of the solar cells.

**Table 2 Performance data of Examples 1 to 6**

| | Open-circuit voltage (V) | Short-circuit current density (mA/cm²) | Fill factor (%) | Eta (%) |
|---|---|---|---|---|
| Example 1 | 0.7364 | 9.246 | 85.66 | 26.46 |
| Example 2 | 0.7364 | 9.251 | 85.76 | 26.50 |
| Example 3 | 0.7411 | 9.296 | 86.24 | 26.67 |
| Example 4 | 0.7381 | 9.278 | 85.71 | 26.62 |
| Example 5 | 0.7384 | 9.280 | 85.55 | 26.59 |
| Example 6 | 0.7381 | 9.276 | 85.57 | 26.57 |

From the performance data of Examples 1 to 6 shown in Table 2, it can be seen that the solar cell of the present disclosure exhibits a high open-circuit voltage, a high short-circuit current density, a high fill factor, and a high photoelectric conversion efficiency. Apparently, the solar cell with the structure according to the present disclosure demonstrates excellent photoelectric conversion performance.

FIG. 8 shows a SEM image of the back side of the solar cell according to Example 1 of the present disclosure. From FIG. 8, it can be seen that the back side of the solar cell has a first step 51 and a second step 52, where the first step 51 includes the first subsurface 511 and the second subsurface 512 intersect with each other, while the second step 52 includes the third subsurface 521 and the fourth subsurface 522 intersect with each other.

## Claims

1. A passivated contact solar cell, comprising:
a silicon substrate (1) comprising a first region (11) and a third region (13) spaced apart from each other on a back side (101) thereof, wherein:
in the first region, the back side of the silicon substrate is sequentially provided with a dielectric layer (2), a first doped layer (3), and a first passivation layer (4) thereon, with the dielectric layer and the first doped layer forming a passivated contact structure in the first region;
in the third region, the back side of the silicon substrate is also provided with the first passivation layer thereon; and
a second region (12) is arranged between the first region and the third region, and is provided with a stepped structure (5) having at least two steps.

2. The passivated contact solar cell according to claim 1, wherein the stepped structure comprises a first step (51) and a second step (52), the first step comprises a first subsurface (511) and a second subsurface (512) intersect with each other, and the second step comprises a third subsurface (521) and a fourth subsurface (522) intersect with each other.

3. The passivated contact solar cell according to claim 2, wherein a distance between the first subsurface and the third subsurface is H₁, where 0.05 µm ≤ I₁ ≤ 0.2 µm.

4. The passivated contact solar cell according to claim 2 or 3, wherein a distance between the third subsurface and a first plane is H₂, where 0.5 µm ≤ H₂ ≤ 8 µm, and the first plane refers to a portion of a first surface of the first passivation layer facing away from the silicon substrate that is located in the third region.

5. The passivated contact solar cell according to any one of claims 2 to 4, wherein an included angle between the third subsurface and the fourth subsurface is α, where α≥90°.

6. The passivated contact solar cell according to any one of claims 2 to 5, wherein the second subsurface intersects with the third subsurface.

7. The passivated contact solar cell according to any one of claims 2 to 6, wherein a width of the third subsurface is W₁, where 0.01 µm ≤ W₁ ≤ 5 µm.

8. The passivated contact solar cell according to any one of claims 2 to 7, wherein in the second region, the back side of the silicon substrate is also provided with the first passivation layer thereon, and a shape of the stepped structure is defined by a back surface of the silicon substrate facing the first passivation layer and a first surface of the first passivation layer facing away from the silicon substrate;
optionally, the first subsurface, the second subsurface, the third subsurface, and the fourth subsurface are each a portion of the first surface of the first passivation layer.
optionally, the first doped layer is either not provided or only partially provided beneath the second step.

9. The passivated contact solar cell according to claim 8, wherein the stepped structure further comprises a texture structure (7) recessed relative to the third subsurface or the fourth subsurface.

10. The passivated contact solar cell according to claim 9, wherein the texture structure is provide at a side of a second surface of the first passivation layer facing the silicon substrate;
optionally, the texture structure is formed by a portion of the back surface of the silicon substrate that is recessed away from the third subsurface or the fourth subsurface.

11. The passivated contact solar cell according to claim 9 or 10, wherein the texture structure is in shape of an inverted pyramid.

12. The passivated contact solar cell according to any one of claims 9 to 11, wherein the texture structure is located on a portion of the silicon substrate corresponding to the third subsurface;
or, the texture structure is located on a portion of the silicon substrate corresponding to the fourth subsurface;
or, the texture structure is located on a portion of the silicon substrate corresponding to a first boundary at which the third subsurface intersects with the fourth subsurface.

13. The passivated contact solar cell according to any one of claims 9 to 12, wherein an average width of the texture structure is W₂, where 0.5 µm ≤ W₂ ≤ 10 µm.

14. The passivated contact solar cell according to any of claims 1 to 13, wherein the first region is provided with a first electrode (61), and the first electrode penetrates through the first passivation layer to be in contact with the first doped layer.

15. A photovoltaic module, comprising the passivated contact solar cell according to any of claims 1 to 14.
